# EUROPÄISCHE PATENTSCHRIFT

(11) **EP 3 552 289 B1**
(45) Veröffentlichungstag und Bekanntmachung des Hinweises auf die Patenterteilung: **04.10.2023**
(21) Anmeldenummer: 17809316.7
(22) Anmeldetag: 07.12.2017
(51) Int. Cl.: H02H 3/02, H01H 9/54, H02H 3/20, H02H 3/027, H02H 3/38, H02H 3/16, H02H 7/26, H01H 83/20

(54) **NIEDERSPANNUNGS-SCHUTZSCHALTGERÄT**
LOW-VOLTAGE CIRCUIT BREAKER DEVICE
DISJONCTEUR BASSE TENSION

(30) Priorität: 09.12.2016 DE 102016123955
(43) Veröffentlichungstag der Anmeldung: 16.10.2019
(73) Patentinhaber: Eaton Intelligent Power Limited, Dublin 4 (IE)
(72) Erfinder: HASLINGER, Stefan, 2522 Oberwaltersdorf (AT)
(74) Vertreter: Epping - Hermann - Fischer
(86) Internationale Anmeldenummer: PCT/EP2017/081809
(87) Internationale Veröffentlichungsnummer: WO 2018/104441

(56) Entgegenhaltungen:
- EP-A1- 2 706 640
- DE-U1-202014 100 301
- GB-A- 2 527 534

## Beschreibung

Die Erfindung betrifft eine Niederspannungs-Schutzschaltgerät gemäß dem Oberbegriff des Patentanspruches 1.

Es sind Schutzschaltgeräte für vielfältige Spezialanwendungen bekannt, welche eine elektrische Instalationsumgebung etwa vor Erdfehlerströmen oder Kurzschlussströmen schützen.

Es sind weiters Schutzschaltgeräte bekannt, welche neben mechanischen Trennkontakten Halbleiterschalter aufweisen. Solche Schaltgeräte werden in der Regel als hybride Schaltgeräte bezeichnet. Ein derartiges hybrides Schaltgerät ist etwa aus der WO 2015/028634 A1 der Anmelderin bekannt.

Nachteilig an all diesen bekannten Schaltgeräten bzw. Schutzkonzepten ist, dass jeweils für die Absicherung ein und desselben elektrischen Teilnetzes gegen die Auswirkungen unterschiedlicher elektrischer Fehler jeweils spezielle Schutzschalter erforderlich sind. So sind für ein und dasselbe Teilnetz derzeit ein Fehlerstrom- bzw. Differenzstromschutzschalter, ein Überstrom/Kurzschluss-Schutzschalter, auch als Leitungsschutzschalter bezeichnet, ein Lichtbogendetektor/Schutzschalter und ein Überspannungsableiter erforderlich, um einen umfänglichen Schutz zu gewährleisten. Dies stellt einen erheblichen Aufwand hinsichtlich der Installation der erforderlichen Gerätschaften und dem Platzbedarf dar. Zudem steigt durch die zunehmende Komplexität der Anzahl an Schutzschaltgeräten der Aufwand zur Abstimmung untereinander. Damit geht ein erhöhtes Risiko von Installationsfehlern für den Installateur einher.

Ein weiterer Nachteil, der all diesen üblichen Schutzschaltgeräten gemein ist, ist der Umstand, dass diese im Notfall bzw. im Falle eines erkannten Fehlers das nachgeschaltete Teilnetz abschalten, und zwar spätestens zum nächsten Nulldurchgang der Versorgungsspannung, was beim europäischen Verbundnetz bedeutet, dass eine Abschaltung nach maximal 10 ms erfolgt. Dies war in der Vergangenheit kein besonderer Nachteil, aufgrund der meist einfachen elektrischen Geräte, stellt jedoch zwischenzeitlich ein erhebliches Problem für die vielfältig eingesetzten Computer dar, welche zwischenzeitlich als sog. Embedded Systems in nahezu allen elektrischen Geräten verbaut werden.

Die EP 2 706 640 A1 offenbart ein System zur Verteilung von Gleichstrom.

Die GB 2 527 534 A beschreibt einen selektiven Schutzschalter.

Die DE 20 2014 100 301 U1 beschreibt eine selektive Überstromschutzvorrichtung.

Aufgabe der Erfindung ist es daher ein Niederspannungs-Schutzschaltgerät der eingangs genannten Art anzugeben, mit welchem die genannten Nachteile vermieden werden können, mit welchem der Installationsaufwand verringert werden kann, und welches eine teilweise bzw. zeitweise Weiterbenützung nachgeschalteter Geräte ermöglicht.

Erfindungsgemäß wird dies durch die Merkmale des Patentanspruches 1 erreicht.

Dadurch kann ein umfassender Schutz von Menschen und Anlagen gegen die mittelbaren wie unmittelbaren Gefahren des elektrischen Stromes mit lediglich einem einzigen Gerät erreicht werden. Dadurch wird der Aufwand an erforderlichen Schutzgeräten drastisch verringert. Dadurch wird vor allem der Installationsaufwand sowie die Möglichkeit hiebei Fehler zu machen deutlich reduziert. Dadurch besteht weiters die Möglichkeit ein nachgeschaltetes Netz nicht gänzlich abzuschalten, sondern für eine kurze aber ausreichende Zeit die an dem Teilnetz, welches dem Neiderspannungs-Schutzschaltgerät nachgeschaltet ist, anliegende Spannung so weit zu reduzieren, dass diese für Menschen und die meisten Anlagen weniger gefährlich, aber gleichzeitig ausreichend hoch für die heute üblichen Schaltnetzteile ist. Dadurch können die Gefahren eines elektrischen Fehlers gebannt werden, während gleichzeitig die Möglichkeit besteht in Form einer Notfallroutine relevante Daten zu sichern bzw. Prozesse zu stoppen, bevor eine gänzliche Abschaltung des Netzes erfolgt.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 ein Blockschaltbild einer ersten bevorzugten Ausführungsform eines gegenständlichen Niederspannungs-Schutzschaltgeräts; und
Fig. 2 ein Blockschaltbild einer zweiten bevorzugten Ausführungsform eines gegenständlichen Niederspannungs-Schutzschaltgeräts.

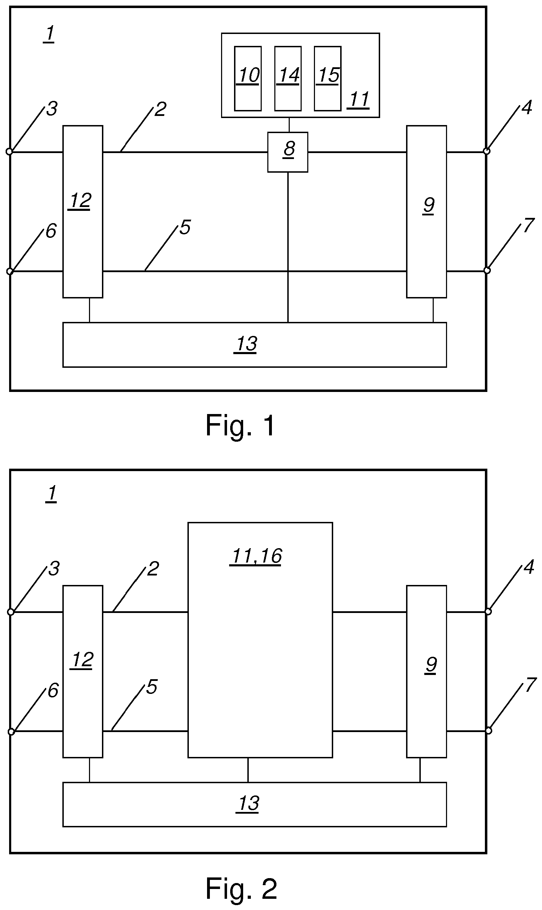

Die Fig. 1 und 2 zeigen jeweils Blockschaltbilder bevorzugter Ausführungsformen eines Niederspannungs-Schutzschaltgerät 1 mit mindestens einer Außenleiterstrecke 2 von einem Außenleiterversorgungsanschluss 3 des Niederspannungs-Schutzschaltgeräts 1 zu einem Außenleiterlastanschluss 4 des Niederspannungs-Schutzschaltgeräts 1, und einer Neutralleiterstrecke 5 von einem Neutralleiteranschluss 6 des Niederspannungs-Schutzschaltgeräts 1 zu einem Neutralleiterlastanschluss 7 des Niederspannungs-Schutzschaltgeräts 1, wobei das Niederspannungs-Schutzschaltgerät 1 eine elektrische Messanordnung 12 aufweist, wobei das Niederspannungs-Schutzschaltgerät 1 wenigstens eine Halbleiterschaltungsanordnung 11 aufweist, und wobei das Niederspannungs-Schutzschaltgerät 1 eine elektronische Steuereinheit 13 aufweist, welche mit der Messanordnung 12 und der Halbleiterschaltungsanordnung 11 verbunden ist, wobei die Messanordnung 12 und/oder die elektronische Steuereinheit 13 zur Detektion einer vorgebbaren Kombination wenigstens zweier, insbesondere dreier, vorzugsweise sämtlicher, elektrischer Fehler ausgewählt aus der Gruppe: Überspannung, Unterspannung, Überstrom, insbesondere Kurzschlussstrom, Fehlerstrom und/oder Lichtbogen, ausgebildet ist, und wobei die Halbleiterschaltungsanordnung 11 zur vorgebbaren Verringerung einer, an Außenleiterlastanschluss 4 und Neutralleiterlastanschluss 7 anliegenden Ausgangsspannung des Niederspannungs-Schutzschaltgeräts 1 gegenüber einer an Außenleiterversorgungsanschluss 3 und Neutralleiteranschluss 6 anliegenden Eingangsspannung des Niederspannungs-Schutzschaltgeräts 1 ausgebildet ist.

Dadurch kann ein umfassender Schutz von Menschen und Anlagen gegen die mittelbaren wie unmittelbaren Gefahren des elektrischen Stromes mit lediglich einem einzigen Gerät erreicht werden. Dadurch wird der Aufwand an erforderlichen Schutzgeräten drastisch verringert. Dadurch wird vor allem der Installationsaufwand sowie die Möglichkeit hiebei Fehler zu machen deutlich reduziert. Dadurch besteht weiters die Möglichkeit ein nachgeschaltetes Netz nicht gänzlich abzuschalten, sondern für eine kurze aber ausreichende Zeit die an dem Teilnetz, welches dem Neiderspannungs-Schutzschaltgerät 1 nachgeschaltet ist, anliegende Spannung so weit zu reduzieren, dass diese für Menschen und die meisten Anlagen weniger gefährlich, aber gleichzeitig ausreichend hoch für die heute üblichen Schaltnetzteile ist. Dadurch können die Gefahren eines elektrischen Fehlers gebannt werden, während gleichzeitig die Möglichkeit besteht in Form einer Notfallroutine relevante Daten zu sichern bzw. Prozesse zu stoppen, bevor eine gänzliche Abschaltung des Netzes erfolgt.

Bei dem gegenständlichen Niederspannungs-Schutzschaltgerät 1 wie auch dem Schutzschaltgerät gemäß der WO 2015/028634 A1 handelt es sich um Niederspannungs-Schutzschaltgeräte. Als Niederspannung wird wie an sich üblich der Bereich bis 1000V Wechselspannung bzw. 1500V Gleichspannung bezeichnet.

Das Niederspannungs-Schutzschaltgerät 1 weist eine Außenleiterstrecke 2 sowie eine Neutralleiterstrecke 5 auf. Die Außenleiterstrecke 2 verläuft durch das Niederspannungs-Schutzschaltgeräte 1 von einem Außenleiterversorgungsanschluss 3 zu einem Außenleiterlastanschluss 4. Die Neutralleiterstrecke 5 verläuft durch das Schutzschaltgerät 1 von einem Neutralleiteranschluss 6 zu einem Neutralleiterlastanschluss 7. Die betreffenden Anschlüsse 3, 4, 6, 7 sind jeweils bevorzugt als Schraubanschlussklemmen bzw. Steckanschlussklemmen ausgebildet, und in dem Niederspannungs-Schutzschaltgeräte 1 von außen zugänglich angeordnet.

Das Niederspannungs-Schutzschaltgerät 1 weist bevorzugt ein Isolierstoffgehäuse auf.

Das Niederspannungs-Schutzschaltgerät 1 kann sowohl ein AC- wie auch ein DC-Niederspannungs-Schutzschaltgerät 1 sein. Die jeweils erforderlichen baulichen Unterschiede zur Anpassung eines Schaltgeräts an die Verwendung bei Gleichstrom sind dem Fachmann geläufig und entsprechend anzuwenden, insbesondere im Bereich der Lichtbogenlöschung.

Eine an Außenleiterversorgungsanschluss 3 und Neutralleiteranschluss 6 anliegende elektrische Spannung wird als Eingangsspannung des Niederspannungs-Schutzschaltgeräts 1 bezeichnet. Diese ist in der Regel identisch mit der jeweils vorherrschenden Spannung des jeweiligen Versorgungsnetzes, etwa 240V. Eine an Außenleiterlastanschluss 4 und Neutralleiterlastanschluss 7 anliegende elektrische Spannung wird Ausgangsspannung des Niederspannungs-Schutzschaltgeräts 1 bezeichnet.

Das Niederspannungs-Schutzschaltgerät 1 weist eine elektrische Messanordnung sowie eine elektronische Steuereinheit 13 auf, wobei die elektrische Messanordnung 12 nachrichtentechnisch mit der elektronischen Steuereinheit 13 verbunden ist.

Es ist vorgesehen, dass die Messanordnung 12 und/oder die elektronische Steuereinheit 13 zur Detektion unterschiedlicher elektrischer Fehler ausgebildet sind. Dabei ist bekannt, dass manche elektrische Fehler, wie etwa Überströme, direkt detektiert werden können, indem ein ermittelter Messwert mit einem Grenzwert verglichen wird. Es ist gleichfalls bekannt, dass auf andere elektrische Fehler, wie insbesondere Lichtbögen, aus einer Analyse eines aufgenommenen Strom- und/oder Spannungsverlaufes geschlossen wird. Entsprechende Algorithmen bzw. Verfahren sind, auch seitens der Anmelderin, bekannt.

Bevorzugt ist die Messanordnung 12 eine Messanordnung zum Messen elektrischer Größen. Insbesondere umfasst die Messanordnung 12 eine Strommessanordnung, vorzugsweise umfassend wenigstens einen Shunt, einen Hallsensor, eine Förstersonde und/oder einen Stromwandler, etwa einen Summenstromwandler. Weiters umfasst die Messanordnung 12 bevorzugt eine Spannungsmessanordnung, vorzugsweise umfassend einen hochohmigen Messwiderstand.

Die elektronische Steuereinheit 13 des Niederspannungs-Schutzschaltgeräts 1 ist bevorzugt umfassend einen Mikrocontroller bzw. Mikroprozessor ausgebildet. Die elektronische Steuereinheit 13 ist dazu ausgebildet, die seitens der Messanordnung 12 gelieferten Messsignale zu verarbeiten und daraus folgend eine Halbleiterschaltungsanordnung 11 und vorzugsweise weitere Baugruppen des Niederspannungs-Schutzschaltgeräts 1 zu steuern.

Es ist vorgesehen, dass das Niederspannungs-Schutzschaltgerät 1 bzw. die Messanordnung 12 in Zusammenspiel mit der elektronischen Steuereinheit 13 dazu bzw. derart ausgebildet sind, eine Mehrzahl, also wenigstens zwei, vorzugsweise

### [Weiter auf Seite 6 der ursprünglichen Beschreibung]

wenigstens drei, elektrische Fehler detektieren zu können. Die elektrischen Fehler sind dabei Fehler ausgewählt aus nachfolgender, nicht zwingend abgeschlossener Gruppe: Überspannung, Unterspannung, Überstrom, insbesondere Kurzschlussstrom, Fehlerstrom und/oder Lichtbogen, wobei es sich bei einem Lichtbogen um einen seriellen und/oder parallelen Lichtbogen handeln kann. Besonders bevorzugt ist das Niederspannungs-Schutzschaltgerät 1 zur Detektion sämtlicher dieser Fehler ausgebildet. Es sei festgehalten, dass das Auftreten eines jeden dieser Fehler für sich allein angestrebt ist, dass aber auch ein gleichzeitiges Auftreten mehrerer Fehler erkannt werden soll. Dies würde etwa bei einem Kurzschluss von Außenleiter auf Erde gegeben sein.

Die elektronische Steuereinheit 13 ist bevorzugt mit einer nicht dargestellten Kommunikationsschnittstelle des Niederspannungs-Schutzschaltgeräts 1 verbunden, um Daten zu den ermittelten Netzzuständen bzw. Fehlern versenden zu können. Dadurch wird die Fehlersuche und Behebung vereinfacht.

Es ist weiters vorgesehen, dass die Halbleiterschaltungsanordnung 11 derart ausgebildet ist, dass diese die Ausgangsspannung des Niederspannungs-Schutzschaltgeräts 1 gegenüber der Eingangsspannung des Niederspannungs-Schutzschaltgeräts 1 vorgebbar verringern kann, wenn diese durch die elektronische Steuereinheit 13 entsprechend angesteuert wird.

Als "Verringern", "Reduzieren" und/oder "Absenken" wird gegenständlich nicht das vollständige Abschalten der Eingangsspannung verstanden. Die Begriffe werden gegenständlich synonym verwendet. Die verringerte Ausgangsspannung soll weiterhin eine elektrische Spannung deutlich größer Null sein. Bevorzugt ist dabei vorgesehen, dass die Ausgangsspannung auf einen Wert reduziert wird, welcher ausreichend hoch ist, damit eine Vielzahl gängiger Schaltnetzteile noch mit dieser Spannung versorgt werden können. Besonders bevorzugt ist daher vorgesehen, dass die Halbleiterschaltungsanordnung 11 dazu ausgebildet und im Niederspannungs-Schutzschaltgerät 1 angeordnet ist, die Ausgangsspannung auf 45 - 50 V AC bzw. 110 - 120 V DC abzusenken.

Die Absenkung der Ausgangsspannung mittels der Halbleiterschaltungsanordnung 11 kann auf unterschiedliche Weise und mit unterschiedlichem Schaltungsaufbau wie auch Betrieb der Schaltung erfolgen.

Gemäß einer ersten bevorzugten Ausführungsform, wie diese in Fig. 1 in Form eines Blockschaltbilds dargestellt ist, ist in der Außenleiterstrecke 2 des Niederspannungs-Schutzschaltgeräts 1 ein mechanischer Bypassschalter 8 angeordnet. Schaltungstechnisch parallel zu diesem ist die Halbleiterschaltungsanordnung 11 angeordnet, welche gemäß der dargestellten bevorzugten Ausführungsform einen Gleichrichter, eine Anzahl Leistungshalbleiter 14, insbesondere einen IGBT, sowie einen Snubber aufweist. Es können diesbezüglich jedoch auch abweichende Schaltungen und Bauteile vorgesehen sein. Beim Öffnen des Bypassschalters 8 kommutiert der Strom auf die zuvor eingeschaltete Halbleiterschaltungsanordnung 11. Durch getaktetes Ein/Ausschalten, etwa entsprechend einer PWM, kann der Strom bzw. die Spannung am Ausgang kontrolliert werden.

Gemäß Fig. 2 ist vorgesehen, dass die Halbleiterschaltungsanordnung 11 als elektrischer Inverter 16 ausgebildet ist, bzw. dass das gesamte Niederspannungs-Schutzschaltgerät 1 ein Inverter ist, welcher die entsprechenden Schutzfunktionen erfüllen kann, und die zusätzlichen Baugruppen aufweist, welche ein herkömmlicher Inverter nicht aufweist. Eine andere Bezeichnung für Inverter 16 ist Wechselrichter. Die Absenkung der Ausgangsspannung ist mittels eines Inverters 16 problemlos möglich und dem Fachmann geläufig. Im Gegensatz zu Fig. 1 befindet sich dabei die Halbleiterschaltungsanordnung 11 ständig im Stromfluss.

Bevorzugt ist vorgesehen, dass die elektronische Steuereinheit 13 und die Halbleiterschaltungsanordnung 11 die Ausgangsspanung innerhalb einer vorgebbaren ersten Zeitspanne vorgebbar absenken bzw. reduzieren, und entsprechend derart ausgebildet sind, eine solche Absenkung durchzuführen. Die erste Zeitspanne beträgt bevorzugt zwischen 0,5 ms und 2 ms, insbesondere im Wesentlichen 1 ms. Durch die schnelle Reduktion der Ausgangsspannung können Schäden für Menschen oder Anlagen verhindert werden. Wie bereist dargelegt, erfolgt diese Absenkung innerhalb der ersten Zeitspanne auf den Spannungswert größer Null.

Nachfolgend ist bevorzugt vorgesehen, die Ausgangsspannung für eine zweite Zeitspanne auf dem abgesenkten Spannungsniveau zu belassen, und nachfolgend gänzlich abzuschalten, daher die Ausgangsspannung auf Null zu bringen. Es ist entsprechend bevorzugt vorgesehen, dass das Niederspannungs-Schutzschaltgerät 1, insbesondere die elektronische Steuereinheit 13 und die

Halbleiterschaltungsanordnung 11, dazu ausgebildet ist, die Ausgangsspanung nach einer vorgebbaren zweiten Zeitspanne nach deren Absenkung abzuschalten. Die zweite Zeitspanne beträgt vorzugsweise zwischen 0,8 s und 1,2 s, insbesondere im Wesentlichen 1 s. Diese Zeit von etwa einer Sekunde ist ausreichend lange um Notspeicherungen sensibler Daten zu ermöglich, wobei gleichzeitig die Verlustleistung an der Halbleiterschaltungsanordnung 11 gering gehalten werden kann.

Zur vollständigen Abschaltung der Ausgangsspannung hat es sich als vorteilhaft erwiesen, dass das Niederspannungs-Schutzschaltgerät 1 elektrische Trennkontakte 9 zur galvanischen Trennung aufweist, und dass die elektrischen Trennkontakte 9 zu deren Ansteuerung mit der elektronischen Steuereinheit 13 verbunden sind. Die betreffenden Trennkontakte 9 sollen dabei lediglich die galvanische Trennung sicherstellen, nachdem die Halbleiterschaltungsanordnung 11 den Stromfluss über das Niederspannungs-Schutzschaltgerät 1 bereits beendet hat.

## Patentansprüche

1. Niederspannungs-Schutzschaltgerät (1) mit mindestens einer Außenleiterstrecke (2) von einem Außenleiterversorgungsanschluss (3) des Niederspannungs-Schutzschaltgeräts (1) zu einem Außenleiterlastanschluss (4) des Niederspannungs-Schutzschaltgeräts (1), und einer Neutralleiterstrecke (5) von einem Neutralleiteranschluss (6) des Niederspannungs-Schutzschaltgeräts (1) zu einem Neutralleiterlastanschluss (7) des Niederspannungs-Schutzschaltgeräts (1), wobei das Niederspannungs-Schutzschaltgerät (1) wenigstens eine Halbleiterschaltungsanordnung (11) und ein Isolierstoffgehäuse aufweist, **dadurch gekennzeichnet, dass** das Niederspannungs-Schutzschaltgerät (1) eine elektrische Messanordnung (12) aufweist, dass das Niederspannungs-Schutzschaltgerät (1) eine elektronische Steuereinheit (13) aufweist, welche mit der Messanordnung (12) und der Halbleiterschaltungsanordnung (11) verbunden ist, dass die Messanordnung (12) und/oder die elektronische Steuereinheit (13) zur Detektion einer vorgebbaren Kombination wenigstens zweier, insbesondere dreier, vorzugsweise sämtlicher, elektrischer Fehler ausgewählt aus der Gruppe: Überspannung, Unterspannung, Überstrom, insbesondere Kurzschlussstrom, Fehlerstrom und/oder Lichtbogen, ausgebildet ist, und dass die Halbleiterschaltungsanordnung (11) zur vorgebbaren Verringerung einer, an Außenleiterlastanschluss (4) und Neutralleiterlastanschluss (7) anliegenden Ausgangsspannung des Niederspannungs-Schutzschaltgeräts (1) gegenüber einer an Außenleiterversorgungsanschluss (3) und Neutralleiteranschluss (6) anliegenden Eingangsspannung des Niederspannungs-Schutzschaltgeräts (1) ausgebildet ist.

2. Niederspannungs-Schutzschaltgerät (1) nach Anspruch 1, **dadurch gekennzeichnet, dass** die elektronische Steuereinheit (13) dazu ausgebildet ist, nach Erkennen wenigstens eines der elektrischen Fehler die Halbleiterschaltungsanordnung (11) zur vorgebbaren Reduktion der Ausgangsspannung anzusteuern.

3. Niederspannungs-Schutzschaltgerät (1) nach Anspruch 1 oder 2, **dadurch gekennzeichnet, dass** die Halbleiterschaltungsanordnung (11) dazu ausgebildet und im Niederspannungs-Schutzschaltgerät (1) angeordnet ist, die Ausgangsspannung auf 45 - 50 V AC bzw. 110 - 120 V DC abzusenken.

4. Niederspannungs-Schutzschaltgerät (1) nach einem der Ansprüche 1 bis 3, **dadurch gekennzeichnet, dass** die elektronische Steuereinheit (13) und die Halbleiterschaltungsanordnung (11) dazu ausgebildet sind, die Ausgangsspanung innerhalb einer vorgebbaren ersten Zeitspanne vorgebbar abzusenken.

5. Niederspannungs-Schutzschaltgerät (1) nach Anspruch 4, **dadurch gekennzeichnet, dass** die erste Zeitspanne zwischen 0,5 ms und 2 ms, insbesondere im Wesentlichen 1 ms, beträgt.

6. Niederspannungs-Schutzschaltgerät (1) nach Anspruch 4 oder 5, **dadurch gekennzeichnet, dass** das Niederspannungs-Schutzschaltgerät (1), insbesondere die elektronische Steuereinheit (13) und die Halbleiterschaltungsanordnung (11), dazu ausgebildet ist, die Ausgangsspanung nach einer vorgebbaren zweiten Zeitspanne nach deren Absenkung abzuschalten.

7. Niederspannungs-Schutzschaltgerät (1) nach Anspruch 6, **dadurch gekennzeichnet, dass** die zweite Zeitspanne zwischen 0,8 s und 1,2 s, insbesondere im Wesentlichen 1 s, beträgt.

8. Niederspannungs-Schutzschaltgerät (1) nach einem der Ansprüche 1 bis 7, **dadurch gekennzeichnet, dass** in der Außenleiterstrecke (2) ein mechanischer Bypassschalter (8) angeordnet ist, wobei die Halbleiterschaltungsanordnung (11) parallel zum Bypassschalter (8) geschaltet ist, wobei die Halbleiterschaltungsanordnung (11) wenigstens einen Leistungshalbleiter (14), insbesondere einen IGBT, umfasst.

9. Niederspannungs-Schutzschaltgerät (1) nach einem der Ansprüche 1 bis 8, **dadurch gekennzeichnet, dass** die Halbleiterschaltungsanordnung (11) als elektrischer Inverter (16) ausgebildet ist.

10. Niederspannungs-Schutzschaltgerät (1) nach einem der Ansprüche 1 bis 9, **dadurch gekennzeichnet, dass** das Niederspannungs-Schutzschaltgerät (1) elektrische Trennkontakte (9) zur galvanischen Trennung aufweist, und dass die elektrischen Trennkontakte (9) zu deren Ansteuerung mit der elektronischen Steuereinheit (13) verbunden sind.

## Claims

1. A low-voltage circuit protection device (1) having at least one outer conductor section (2) from an outer conductor supply terminal (3) of the low-voltage circuit protection device (1) to an outer conductor load terminal (4) of the low-voltage circuit protection device (1), and a neutral conductor section (5) from a neutral conductor terminal (6) of the low-voltage circuit protection device (1) to a neutral conductor load terminal (7) of the low-voltage circuit protection device (1), wherein the low-voltage circuit protection device (1) has at least one semiconductor circuit arrangement (11) and an insulating material housing, **characterized in that** the low-voltage circuit protection device (1) has an electrical measuring arrangement (12), **in that** the low-voltage circuit protection device (1) has an electronic control unit (13) which is connected to the measuring arrangement (12) and the semiconductor circuit arrangement (11), **in that** the measuring arrangement (12) and/or the electronic control unit (13) is designed to detect a specifiable combination of at least two, in particular three, preferably all, electrical faults selected from the group: overvoltage, undervoltage, overcurrent, in particular short-circuit current, fault current and/or arc, and **in that** the semiconductor circuit arrangement (11) is designed to reduce, in a specifiable manner, an output voltage of the low-voltage circuit protection unit (1) applied at the outer conductor load terminal (4) and the neutral conductor load terminal (7) relative to an input voltage of the low-voltage circuit protection device (1) applied to the outer conductor supply terminal (3) and neutral conductor terminal (6).

2. The low-voltage circuit protection device (1) according to claim 1, **characterized in that** the electronic control unit (13) is designed to control the semiconductor circuit arrangement (11) for the specifiable reduction of the output voltage after at least one of the electrical faults has been detected.

3. The low-voltage circuit protection device (1) according to claim 1 or 2, **characterized in that** the semiconductor circuit arrangement (11) is designed and arranged in the low-voltage circuit protection device (1) to lower the output voltage to 45 - 50 V AC and 110 - 120 V DC.

4. The low-voltage circuit protection device (1) according to any of claims 1 to 3, **characterized in that** the electronic control unit (13) and the semiconductor circuit arrangement (11) are designed to reduce, in a specifiable manner, the output voltage within a specifiable first time period.

5. The low-voltage circuit protection device (1) according to claim 4, **characterized in that** the first time period is between 0.5 ms and 2 ms, in particular substantially 1 ms.

6. The low-voltage circuit protection device (1) according to claim 4 or 5, **characterized in that** the low-voltage circuit protection device (1), in particular the electronic control unit (13) and the semiconductor circuit arrangement (11), is designed to switch off the output voltage after a specifiable second time period after it has been lowered.

7. The low-voltage circuit protection device (1) according to claim 6, **characterized in that** the second time period is between 0.8 s and 1.2 s, in particular substantially 1 s.

8. The low-voltage circuit protection device (1) according to any of claims 1 to 7, **characterized in that** a mechanical bypass switch (8) is arranged in the outer conductor section (2), wherein the semiconductor circuit arrangement (11) is connected in parallel to the bypass switch (8), wherein the semiconductor circuit arrangement (11) comprises at least one power semiconductor (14), in particular an IGBT.

9. The low-voltage circuit protection device (1) according to any of claims 1 to 8, **characterized in that** the semiconductor circuit arrangement (11) is designed as an electrical inverter (16).

10. The low-voltage circuit protection device (1) according to any of claims 1 to 9, **characterized in that** the low-voltage circuit protection device (1) has electrical isolating contacts (9) for galvanic isolation, and **in that** the electrical isolating contacts (9) are connected to the electronic control unit (13) in order to be controlled.

## Revendications

1. Disjoncteur basse tension (1) comportant au moins une ligne de conducteur extérieur (2) d'un raccord d'alimentation de conducteur externe (3) du disjoncteur basse tension (1) à un raccord de charge de conducteur extérieur (4) du disjoncteur basse tension (1) et une ligne de conducteur neutre (5) d'un raccord de conducteur neutre (6) du disjoncteur basse tension (1) à un raccord de charge de conducteur neutre (7) du disjoncteur basse tension (1), dans lequel le disjoncteur basse tension (1) présente au moins un agencement de circuit semi-conducteur (11) et un boîtier en matériau isolant, **caractérisé en ce que** le disjoncteur basse tension (1) présente un agencement de mesure électrique (12), que le disjoncteur basse tension (1) présente une unité de commande électronique (13), qui est reliée à l'agencement de mesure (12) et à l'agencement de circuit semi-conducteur (11), que l'agencement de mesure (12) et/ou l'unité de commande électronique (13) est/sont conçue/conçus pour la détection d'une combinaison pouvant être prédéfinie d'au moins deux, en particulier trois, de préférence la totalité, défauts électriques choisis dans le groupe : surtension, sous-tension, surintensité, en particulier court-circuit, courant de fuite et/ou arc électrique et que l'agencement de circuit semi-conducteur (11) est conçu pour réduire de manière pouvant être prédéfinie une tension de sortie appliquée au raccord de charge de conducteur extérieur (4) et au raccord de charge de conducteur neutre (7) du disjoncteur basse tension (1) par rapport à une tension d'entrée appliquée au raccord d'alimentation de conducteur extérieur (3) et au raccord de conducteur neutre (6) du disjoncteur basse tension (1).

2. Disjoncteur basse tension (1) selon la revendication 1, **caractérisé en ce que** l'unité de commande électronique (13) est conçue pour, lors de la reconnaissance d'au moins un défaut électrique, commander l'agencement de circuit semi-conducteur (11) pour la réduction pouvant être prédéfinie de la tension de sortie.

3. Disjoncteur basse tension (1) selon la revendication 1 ou 2, **caractérisé en ce que** l'agencement de circuit semi-conducteur (11) est conçu et agencé dans le disjoncteur basse tension (1), pour diminuer la tension de sortie à 45 - 50 V CA respectivement 110 - 120 V CC.

4. Disjoncteur basse tension (1) selon l'une des revendications 1 à 3, **caractérisé en ce que** l'unité de commande électronique (13) et l'agencement de circuit semi-conducteur (11) sont conçus pour diminuer de manière pouvant être prédéfinie la tension de sortie au sein d'un premier intervalle pouvant être prédéfini.

5. Disjoncteur basse tension (1) selon la revendication 4, **caractérisé en ce que** le premier intervalle est compris entre 0,5 ms et 2 ms, en particulier vaut essentiellement 1 ms.

6. Disjoncteur basse tension (1) selon la revendication 4 ou 5, **caractérisé en ce que** le disjoncteur basse tension (1), en particulier l'unité de commande électronique (13) et l'agencement de circuit semi-conducteur (11), est conçu pour couper la tension de sortie après un second intervalle pouvant être prédéfini après sa diminution.

7. Disjoncteur basse tension (1) selon la revendication 6, **caractérisé en ce que** le second intervalle est compris entre 0,8 s et 1,2 s, en particulier vaut essentiellement 1 s.

8. Disjoncteur basse tension (1) selon l'une des revendications 1 à 7, **caractérisé en ce que,** dans la ligne de conducteur externe (2), un commutateur de dérivation mécanique (8) est agencé, dans lequel l'agencement de circuit semi-conducteur (11) est branché en parallèle avec le commutateur de dérivation (8), dans lequel l'agencement de circuit semi-conducteur (11) comprend au moins un semi-conducteur de puissance (14), en particulier un IGBT.

9. Disjoncteur à basse tension (1) selon l'une des revendications 1 à 8, **caractérisé en ce que** l'agencement de circuit semi-conducteur (11) est conçu comme un onduleur électrique (16).

10. Disjoncteur basse tension (1) selon l'une des revendications 1 à 9, **caractérisé en ce que** le disjoncteur basse tension (1) présente des contacts de séparation électrique (9) pour la séparation galvanique et que les contacts de séparation électrique (9) sont reliés, pour leur commande, à l'unité de commande électronique (13).
